# EUROPEAN PATENT APPLICATION

(11) **EP 4 835 954 A1**
(43) Date of publication of application: **04.11.2026**
(21) Application number: 24911929.8
(22) Date of filing: 15.10.2024
(51) Int. Cl.: H01L 21/304, H01L 21/027

(54) **SUBSTRATE PROCESSING APPARATUS AND SUBSTRATE PROCESSING METHOD**

(30) Priority: 28.12.2023 JP 2023223629
(71) Applicant: SCREEN Holdings Co., Ltd., Kyoto-shi, Kyoto 602-8585 (JP)
(72) Inventor: HIGUCHI, Tomomi, Kyoto-shi, Kyoto 602-8585 (JP)
(74) Representative: Kilian Kilian & Partner mbB
(86) International application number: PCT/JP2024/036585
(87) International publication number: WO 2025/142036

(57) **Abstract**

A substrate processing apparatus includes a first liquid supply system, a second liquid supply system, and a nozzle. The first liquid supply system includes a first pipe connected to the nozzle, and supplies a first liquid to the nozzle through a first pipe. The second liquid supply system includes a plurality of second sub-pipes respectively connected to a plurality of different portions of a liquid flow path formed by the nozzle and the first pipe. A period of a removal process of removing an unnecessary film formed on a substrate includes a first period and a second period. In the first period, a second liquid is supplied to the liquid flow path from a second sub-pipe connected to a portion other than a most downstream portion of the liquid flow path. In the second period, the second liquid is supplied to the liquid flow path from the second sub-pipe connected to the most downstream portion of the liquid flow path.

## Description

### [Technical Field]

The present invention relates to a substrate processing apparatus that removes an unnecessary film formed on one surface of a substrate, and a substrate processing method of removing the unnecessary film formed on the one surface of the substrate.

### [Background Art]

A substrate processing apparatus is used to execute various processes on a substrate such as a semiconductor substrate, a substrate for a flat panel display (FPD) that is used for a liquid crystal display device, an organic electroluminescence (EL) display device, or the like, a substrate for an optical disc, a substrate for a magnetic disc, a substrate for a magneto-optical disc, a substrate for a photomask, a ceramic substrate or a substrate for a solar cell.

In a substrate processing apparatus described in Patent Document 1, an unnecessary resist film formed on one surface of a substrate (wafer) is removed using a sulfuric acid hydrogen peroxide mixture (SPM). More specifically, the substrate having the resist film is held in a horizontal posture by a spin chuck, and rotated about a vertical axis. In this state, an SPM nozzle is disposed at a position above the rotating substrate, and the SPM is supplied from the SPM nozzle toward the rotation center of the substrate. The SPM is a mixed liquid of sulfuric acid (H₂SO₄) and a hydrogen peroxide solution (H₂O₂), and has a strong oxidizing power. Thus, the resist film on the substrate is stripped off and removed from the one surface of the substrate by the oxidizing power of the SPM.

[Patent Document 1]JP 2008-4819 A

### [Summary of Invention]

### [Technical Problem]

In a case in which the SPM is supplied onto the substrate having the resist film, a plurality of portions of the resist film are not necessarily uniformly removed. When a period of time required for supplying the SPM to the substrate is increased in order to reliably remove a portion of the resist film that is unlikely to be removed from the one surface of the substrate, efficiency of processing the substrate is degraded.

An object of the present invention is to provide a substrate processing apparatus and a substrate processing method that can improve efficiency of processing a substrate.

### [Solution to Problem]

A substrate processing apparatus according to one aspect of the present invention executes a removal process of removing, using a processing liquid including Caro's acid, an unnecessary film formed on one surface of a substrate, wherein in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid, the substrate processing apparatus includes a nozzle that discharges the processing liquid to the one surface of the substrate, a first liquid supply system that includes a first pipe connected to the nozzle, and supplies the first liquid to the nozzle through the first pipe, a second liquid supply system that includes a plurality of second pipes respectively connected to a plurality of different portions of a liquid flow path formed by the nozzle and the first pipe, and supplies the second liquid to the liquid flow path through any one of the plurality of second pipes, and a count of the plurality of second pipes and a count of the plurality of different portions are respectively equal to or larger than three, and a controller that controls the second liquid supply system, the plurality of second pipes include a downstream pipe connected to a most downstream portion among the plurality of portions of the liquid flow path, and a plurality of upstream pipes excluding the downstream pipe, and the controller executes a first control of, in a first period during the removal process for one substrate, not causing the second liquid to flow through the downstream pipe and causing the second liquid to flow through at least two upstream pipes among the plurality of upstream pipes, and executes a second control of, in a second period during the removal process for the one substrate, causing the second liquid to flow through the downstream pipe and not causing the second liquid to flow through the plurality of upstream pipes.

A substrate processing method according to yet another aspect of the present invention is executed using a substrate processing apparatus, with the substrate processing apparatus executing a removal process of removing, using a processing liquid including Caro's acid, an unnecessary film formed on one surface of a substrate, wherein in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid, the substrate processing apparatus includes a nozzle that discharges the processing liquid to the one surface of the substrate, a first liquid supply system that includes a first pipe connected to the nozzle, and supplies the first liquid to the nozzle through the first pipe, a second liquid supply system that includes a plurality of second pipes respectively connected to a plurality of different portions of a liquid flow path formed by the nozzle and the first pipe, and supplies the second liquid to the liquid flow path through any one of the plurality of second pipes, and a count of the plurality of second pipes and a count of the plurality of different portions are respectively equal to or larger than three, and the plurality of second pipes include a downstream pipe connected to a most downstream portion among the plurality of portions of the liquid flow path, and a plurality of upstream pipes excluding the downstream pipe, and the substrate processing method includes the steps of executing a first control of, in a first period during the removal process for one substrate, not causing the second liquid to flow through the downstream pipe and causing the second liquid to flow through at least two upstream pipes among the plurality of upstream pipes, and executing a second control of, in a second period during the removal process for the one substrate, causing the second liquid to flow through the downstream pipe and not causing the second liquid to flow through the plurality of upstream pipes.

### [Advantageous Effects of Invention]

The present invention enables the efficiency of processing a substrate to be improved.

### [Brief Description of the Drawings]

[FIG. 1] Fig. 1 is a schematic diagram showing the configuration of a substrate processing apparatus according to one embodiment of the present invention.
[FIG. 2] Fig. 2 is a plan view of the substrate processing apparatus for explaining functions of a nozzle supporter and a nozzle moving device of Fig. 1.
[FIG. 3] Fig. 3 is a block diagram showing the configuration of a control system of the substrate processing apparatus of Fig. 1.
[FIG. 4] Fig. 4 is a schematic diagram showing a result of a film removal experiment on a first sample substrate.
[FIG. 5] Fig. 5 is a schematic diagram showing a result of a film removal experiment on a second sample substrate.
[FIG. 6] Fig. 6 is a diagram showing one example of work conditions stored in a storage device of Fig. 3.
[FIG. 7] Fig. 7 is a flowchart showing one example of a film removal process executed by a controller of Fig. 1.

### [Description of Embodiments]

A substrate processing apparatus and a substrate processing method according to one embodiment of the present invention will be described below with reference to the drawings. In the following description, a substrate refers to a substrate for a flat panel display (FPD) that is used for a liquid crystal display device, an organic electroluminescence (EL) display device, or the like, a semiconductor substrate, a substrate for an optical disc, a substrate for a magnetic disc, a substrate for a magneto-optical disc, a substrate for a photomask, a ceramic substrate, a substrate for a solar cell, or the like.

Further, the substrate processing apparatus, described below, is a single-wafer substrate processing apparatus, and is used for a removal process of removing an unnecessary film (a resist film in the present example) formed on one surface (main surface) of the substrate. In the removal process according to the present embodiment, the substrate having the unnecessary film formed on the one surface thereof is rotated in a horizontal posture. A sulfuric acid hydrogen peroxide mixture (SPM) is supplied as a processing liquid to the one surface of the substrate. The SPM is a mixed liquid of sulfuric acid (H₂SO₄) and a hydrogen peroxide solution (H₂O₂), and includes Caro's acid (H₂SO₅). Caro's acid is generated by the chemical reaction between sulfuric acid and a hydrogen peroxide solution, has a strong oxidizing power, and dissolves the unnecessary film by reacting with the film. This causes the unnecessary film to be stripped from the one surface of the substrate and removed.

### <1> Configuration of Substrate Processing Apparatus

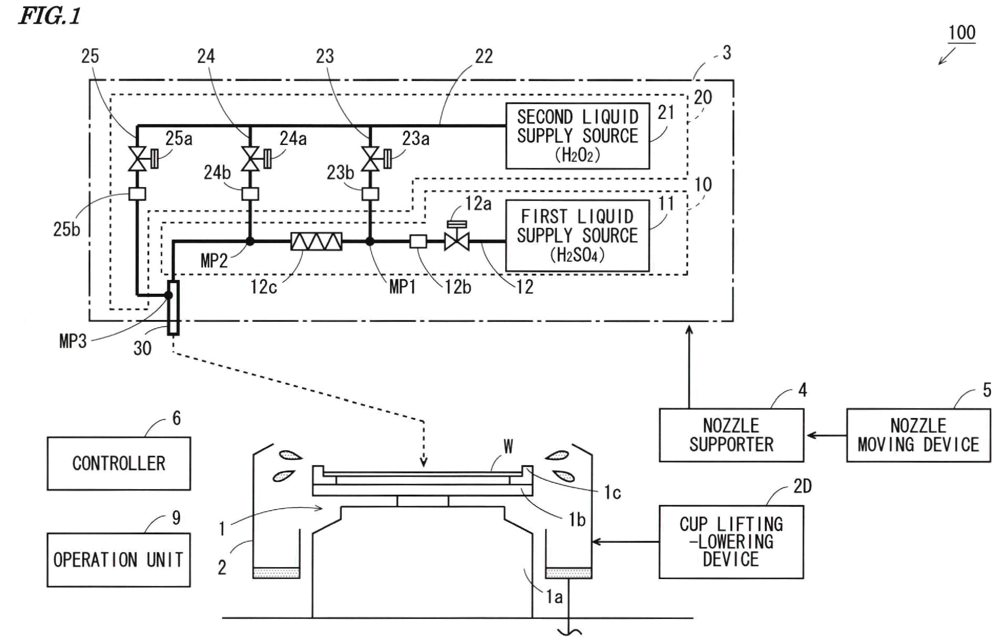

Fig. 1 is a schematic diagram showing the configuration of the substrate processing apparatus according to one embodiment of the present invention. As shown in Fig. 1, the substrate processing apparatus 100 mainly includes a spin chuck 1, a cup 2, a cup lifting-lowering device 2D, a processing liquid supply device 3, a nozzle supporter 4, a nozzle moving device 5, a controller 6, and an operation unit 9.

At least part of the substrate processing apparatus 100 is provided in a chamber (not shown). The spin chuck 1 has a spin motor 1a, a spin base 1b, and chuck pins 1c. The spin motor 1a is provided in a bottom portion of the chamber such that a rotation shaft projects upwardly. The spin base 1b has a disc shape, and is attached to an upper end portion of the rotation shaft of the spin motor 1a in a horizontal posture. The plurality of chuck pins 1c are provided on an upper surface of the spin base 1b, and hold a peripheral portion of the substrate W. The spin motor 1a works with the plurality of chuck pins 1c holding the substrate W. This causes the substrate W to rotate about a vertical axis.

As described above, in the present example, the mechanical spin chuck 1 that holds the peripheral portion of the substrate W is used. Instead of the mechanical spin chuck, a suction-type spin chuck that holds a lower surface of the substrate W by suction may be used.

The cup 2 is provided so as to surround the spin chuck 1. The cup 2 is supported by the cup lifting-lowering device 2D such that the cup 2 can be lifted and lowered. The cup lifting-lowering device 2D includes an air cylinder, or the like, and moves the cup 2 between two predetermined height positions (an upper position and a lower position, described below).

The processing liquid supply device 3 mainly includes a first liquid supply system 10, a second liquid supply system 20, and a nozzle 30. The first liquid supply system 10 includes a first liquid supply source 11, a first pipe 12, a valve 12a, an adjuster 12b, and a stirrer 12c. The first liquid supply source 11 is a supply source of sulfuric acid, and includes a utility facility of a factory, a liquid sending device including a liquid storage, or the like. An upstream end of the first pipe 12 is connected to the first liquid supply source 11. A downstream end of the first pipe 12 is connected to the nozzle 30. The valve 12a, the adjuster 12b, and the stirrer 12c are provided in the first liquid supply source 11 so as to be arranged in this order from the upstream end to the downstream end of the first liquid supply source 11.

The valve 12a is a ball valve, for example, allows a liquid flow in the first pipe 12 when the valve 12a is in an open state, and blocks a liquid flow in the first pipe 12 when the valve 12a is in a close state. The adjuster 12b includes a flow-rate adjuster such as a motor needle valve or a regulator, and adjusts a flow rate of a liquid flowing through the first pipe 12. In the present example, the adjuster 12b is a motor needle valve. The stirrer 12c is an in-line mixer, for example, and mixes a plurality of types of liquids (sulfuric acid and a hydrogen peroxide solution in the present example) flowing through the first pipe 12 by generating a vortex flow or the like in the first pipe 12.

In the present embodiment, of a liquid flow path formed by the first pipe 12 and the nozzle 30, a portion located between the adjuster 12b and the stirrer 12c is referred to as a first portion MP1. Further, a portion located between the stirrer 12c and the nozzle 30 is referred to as a second portion MP2, and a portion located at the nozzle 30 is referred to as a third portion MP3.

The second liquid supply system 20 includes a second liquid supply source 21, a second main pipe 22, a plurality (three in the present example) of second sub-pipes 23, 24, 25, a plurality (three in the present example) of valves 23a, 24a, 25a, and a plurality (three in the present example) of adjusters 23b, 24b, 25b. The second liquid supply source 21 is a supply source of the hydrogen peroxide solution, and similarly to the example of the first liquid supply source 11, includes a utility facility of a factory, a liquid sending device including a liquid storage, or the like.

An upstream end of the second main pipe 22 is connected to the second liquid supply source 21. The second main pipe 22 has a plurality (two in the present example) of branch portions arranged from an upstream position toward a downstream position. Upstream ends of the second sub-pipes 23, 24, 25 are respectively connected to an upstream branch portion of the second main pipe 22, a downstream branch portion of the second main pipe 22, and a downstream end of the second main pipe 22. On the other hand, downstream ends of the second sub-pipes 23, 24, 25 are respectively connected to the first portion MP1, the second portion MP2, and the third portion MP3 of the above-mentioned liquid flow path.

In the second sub-pipe 23, the valve 23a and the adjuster 23b are provided in this order from an upstream position toward a downstream position. In the second sub-pipe 24, the valve 24a and the adjuster 24b are arranged in this order from an upstream position toward a downstream position. In the second sub-pipe 25, the valve 25a and the adjuster 25b are arranged in this order from an upstream position toward a downstream position.

The valves 23a, 24a, 25a have the same configuration as that of the valve 12a. Further, the adjusters 23b, 24b, 25b have the same configuration as that of the adjuster 12b. At least one of the valves 12a, 23a, 24a, 25a may have a configuration different from those of the other valves. At least one of the adjusters 12b, 23b, 24b, 25b may also have a configuration different from those of the other adjusters.

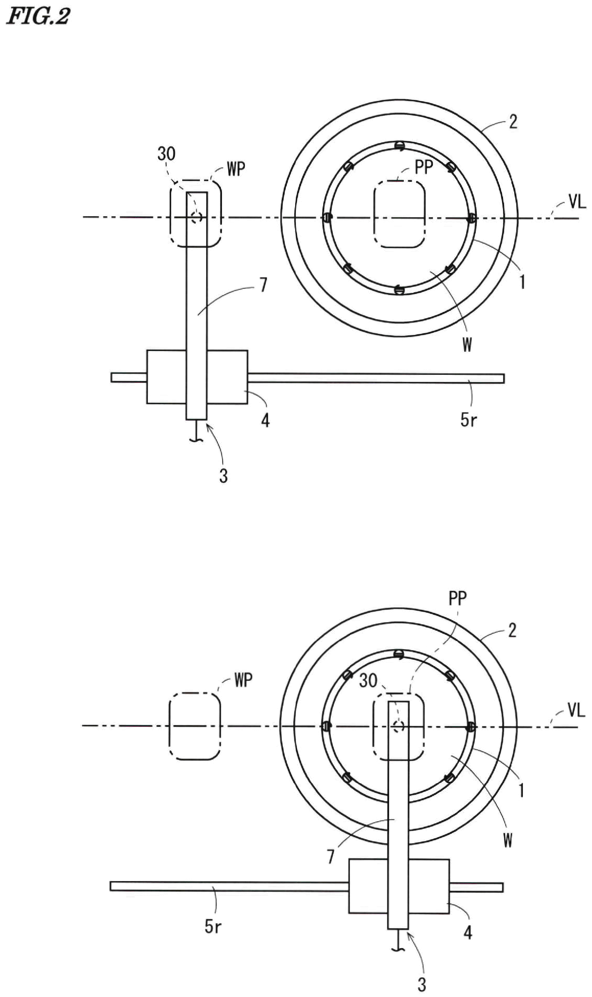

In the above-mentioned processing liquid supply device 3, the configuration of the first liquid supply system 10 and the configuration of the second liquid supply system 20 are partially supported above the spin chuck 1 by an arm member 7 (Fig. 2) made of a hard resin, for example.

Fig. 2 is a plan view of the substrate processing apparatus 100 for explaining functions of the nozzle supporter 4 and the nozzle moving device 5 of Fig. 1. As shown in the upper field of Fig. 2, a rail 5r is provided at a bottom portion of the chamber and sideward of the spin chuck 1 and the cup 2 in plan view. The rail 5r is provided so as to extend in one direction at a position close to the spin chuck 1 and the cup 2. In the following description, the direction in which the rail 5r extends in plan view is referred to as a rail direction. Further, in plan view, a straight line passing through a rotation center of the spin chuck 1 and extending in the rail direction is referred to as a virtual line VL.

The arm member 7 supporting part of the processing liquid supply device 3 has a rod shape, for example, and supports the nozzle 30 using its tip end portion. The nozzle supporter 4 supports the arm member 7 such that the nozzle 30 is located on the virtual line VL, and is provided on the rail 5r so as to be movable in the rail direction. A motor forming part of the nozzle moving device 5 is attached to the nozzle supporter 4. This causes the nozzle supporter 4 to move on the rail 5r when the nozzle moving device 5 works.

In the substrate processing apparatus 100, in plan view, a waiting position WP is set at a position on the virtual line VL deviated from the spin chuck 1 and the cup 2. Further, in plan view, a processing position PP is set at a position overlapping with the rotation center of the spin chuck 1 on the virtual line VL. In a case in which the substrate processing apparatus 100 is in a waiting state where not executing the removal process, the nozzle 30 of the processing liquid supply device 3 is held at the waiting position WP in plan view as shown in the upper field of Fig. 2. On the other hand, in a case in which the substrate processing apparatus 100 executes the removal process, the nozzle 30 of the processing liquid supply device 3 is held at the processing position PP in plan view as shown in the lower field of Fig. 2.

In the present embodiment, with the nozzle 30 of the processing liquid supply device 3 being held at the processing position PP during the removal process, the nozzle 30 is positioned such that a discharge port of the nozzle 30 is opposite to the rotation center of the spin chuck 1. In the present embodiment, the center of the substrate W being held by the spin chuck 1 is located on the vertical axis passing through the rotation center of the spin chuck 1. Thus, in the present embodiment, when the nozzle 30 is held at the processing position PP, the discharge port of the nozzle 30 is opposite to the center of the substrate W.

During the removal process, the processing liquid is discharged from the discharge port of the nozzle 30 of the processing liquid supply device 3 toward the one surface of the substrate W. The discharged processing liquid collides with the one surface of the substrate W (more precisely, the one surface of the substrate W or the resist film covering the one surface of the substrate W), and then spreads in a radial direction from the center of the substrate W toward an outer peripheral end of the substrate W due to a centrifugal force.

The substrate processing apparatus 100 according to the present embodiment includes a rinse nozzle (not shown), and a rinse liquid supply system (not shown) that supplies a rinse liquid to the rinse nozzle. After the resist film is removed by the processing liquid, the rinse nozzle discharges the rinse liquid toward the one surface of the substrate W on which the processing liquid remains. This removes the processing liquid on the substrate W (a rinsing process). Details of the controller 6 and the operation unit 9 will be described below.

### <2> Control System of Substrate Processing Apparatus

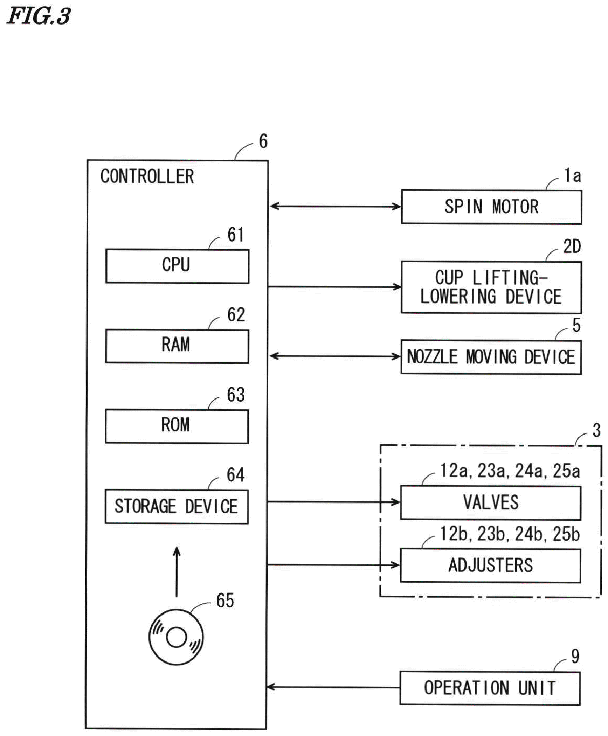

A control system of the substrate processing apparatus 100 will be described together with configurations of the controller 6 and the operation unit 9 of Fig. 1. Fig. 3 is a block diagram showing the configuration of the control system of the substrate processing apparatus 100 of Fig. 1. As shown in Fig. 3, the controller 6 includes a central processing unit (CPU) 61, a random access memory (RAM) 62, a read only memory (ROM) 63, and a storage device 64.

The RAM 62 is used as a work area for the CPU 61. A system program is stored in the ROM 63. The storage device 64 includes a storage medium such as a hard disc or a semiconductor memory, and stores a film removal program for executing the removal process. Further, the storage device 64 stores a work condition of the substrate processing apparatus 100 relating to the removal process. Details of the work condition will be described below.

The film removal program may be provided in the state of being stored in a recording medium such as a CD-ROM 65, and installed in the ROM 63 or the storage device 64. Alternatively, the film removal program may be distributed from a server outside of the substrate processing apparatus 100 via a communication network, and installed in the ROM 63 or the storage device 64.

The CPU 61 executes the film removal program, thereby controlling the work of each component of the substrate processing apparatus 100 during the removal process. Specifically, with the substrate W placed on the spin base 1b and held by the plurality of chuck pins 1c, the controller 6 rotates the substrate W by controlling the spin motor 1a.

The controller 6 also controls the cup lifting-lowering device 2D such that the cup 2 is held at the lower position when the substrate W is placed on the spin chuck 1, when the substrate W is taken out from the spin chuck 1, and when the removal process is not executed. Here, the lower position refers to a position of the cup 2 when an upper end portion of the cup 2 is located below the substrate W held by the spin chuck 1.

Further, during the removal process, the controller 6 controls the cup lifting-lowering device 2D such that the cup 2 is held at the upper position. Here, the upper position refers to a position of the cup 2 when the upper end portion of the cup 2 is above the substrate W held by the spin chuck 1 and an inner peripheral surface of the cup 2 faces the outer peripheral end of the substrate W in a horizontal plane. In this case, the processing liquid splashing from the substrate W during the removal process is received by the inner peripheral surface of the cup 2. The processing liquid received by the cup 2 is discarded through a drain pipe.

Further, during the removal process, the controller 6 controls the nozzle moving device 5 such that the nozzle 30 of the processing liquid supply device 3 is held at the processing position PP. Further, in a period during which the removal process is not executed, the controller 6 controls the nozzle moving device 5 such that the nozzle 30 of the processing liquid supply device 3 is held at the waiting position WP.

As described above, the work condition of the substrate processing apparatus 100 relating to the removal process is stored in the storage device 64 of the controller 6. During the removal process, the controller 6 controls the plurality of valves 12a, 23a, 24a, 25a and the plurality of adjusters 12b, 23b, 24b, 25b of the processing liquid supply device 3 based on the work condition stored in the storage device 64. In this case, in the processing liquid supply device 3, with the sulfuric acid flowing through the first pipe 12, the hydrogen peroxide solution is supplied from the second liquid supply system 20 to any one of the first portion MP1, the second portion MP2, and the third portion MP3 of the liquid flow path. This causes the sulfuric acid and the hydrogen peroxide solution to be mixed in the liquid flow path, and the processing liquid (SPM) is generated.

The operation unit 9 of Fig. 1 includes a keyboard and a pointing device, and is configured to be operable by a user. The user can input the above-mentioned work condition by operating the operation unit 9. When the work condition is input using the operation unit 9, the controller 6 stores the input work condition in the storage device 64.

### <3> Change of State When Film on Substrate W Is Removed

As described in the section of Technical Problem, in the process of removing the resist film, even when the processing liquid including Caro's acid is supplied onto the one surface of the substrate W, a plurality of portions of the resist film on the one surface of the substrate W are not necessarily uniformly removed. The inventor of the present invention focused on this point, and assumed that a method of generating the processing liquid might contribute to the non-uniformity of removal of the resist film. As such, the inventor of the present invention conducted the following film removal experiment using the processing liquid supply device 3 having the above-mentioned configuration of Fig. 1.

First, the inventor of the present invention prepared two sample substrates on which resist films were formed by a common method. In the following description, the two sample substrates are respectively referred to as a first sample substrate and a second sample substrate. The inventor of the present invention supplied processing liquids respectively generated by different methods to the first sample substrate and the second sample substrate, and observed changes in resist films on the respective substrates during the supply of the processing liquids.

Specifically, the inventor of the present invention positioned the nozzle 30 such that, with the first sample substrate being held in a horizontal posture and rotated by the spin chuck 1, the nozzle 30 was opposite to the center of the substrate W. The inventor of the present invention also opened the three valves 12a, 23a, 24a of the processing liquid supply device 3 of Fig. 1 and closed the valve 25a.

Here, in the processing liquid supply device 3, each of the adjusters 12b, 23b, 24b, 25b adjusts a flow rate of liquid such that, in a case in which the liquid flows through the pipe to which the adjuster is attached, the flow rate of liquid is a predetermined flow rate.

In this case, in the processing liquid supply device 3, the sulfuric acid is supplied from the first liquid supply source 11 to the first pipe 12 at the predetermined flow rate. Further, the hydrogen peroxide solution is supplied from the second liquid supply source 21 to the first portion MP1 of the liquid flow path through the second main pipe 22 and the second sub-pipe 23. Thus, the sulfuric acid and the hydrogen peroxide solution merge in the first portion MP1, and the mixed liquid is sent to the stirrer 12c. In the stirrer 12c, the liquid (the mixed liquid of the sulfuric acid and the hydrogen peroxide solution in the present example) flowing inside of the stirrer 12c is stirred. The hydrogen peroxide solution is also supplied from the second liquid supply source 21 to the second portion MP2 of the liquid flow path through the second main pipe 22 and the second sub-pipe 24. Thus, the mixed liquid and a new hydrogen peroxide solution merge in the second portion MP2, and the mixed liquid is sent to the nozzle 30 as the processing liquid.

The inventor of the present invention captured an image of the one surface of the first sample substrate using a camera every sixty seconds from a start point in time of the supply of the processing liquid to the first sample substrate. Based on the images obtained by imaging, the inventor of the present invention also confirmed a temporal change of the resist film during the removal process for the first sample substrate.

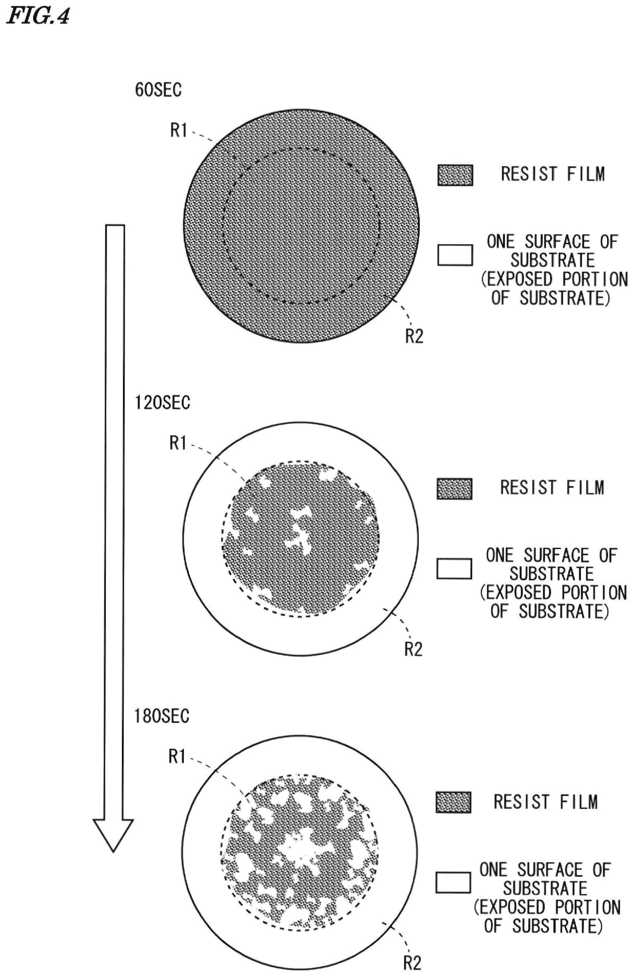

Fig. 4 is a schematic diagram showing a result of the film removal experiment on the first sample substrate. In the upper field of Fig. 4, a plan view of the first sample substrate at a point in time at which sixty seconds have elapsed since the start point in time of the supply of the processing liquid is shown. In the middle field of Fig. 4, a plan view of the first sample substrate at a point in time at which 120 seconds have elapsed since the start point in time of the supply of the processing liquid is shown. In the lower field of Fig. 4, a plan view of the first sample substrate at a point in time at which 180 seconds have elapsed since the start point in time of the supply of the processing liquid is shown.

Each plan view of Fig. 4 schematically shows an image of the first sample substrate obtained by imaging the first sample substrate. In each of the plan views in the upper, middle, and lower fields of Fig. 4, the resist film present on the one surface of the first sample substrate is indicated by the dotted pattern.

In the following description, the ratio (rate) of an area from which the resist film is removed to an area of the entire one surface of the substrate is referred to as a resist-film removal rate. Further, in the one surface of the substrate, an inner portion R1 and an outer portion R2 are defined. The inner portion R1 has a circular shape, and is located at the center of the substrate. The radius of the inner portion R1 is about 2/3 of the radius of the substrate. The outer portion R2 has an annular shape including the outer peripheral end of the substrate W, and surrounds the inner portion R1.

As shown in the upper field of Fig. 4, at a point in time at which sixty seconds have elapsed since the start point in time of the supply of the processing liquid, the resist film is hardly removed from the entire first sample substrate. The resist-film removal rate in the first sample substrate at this time was about 4 %.

As shown in the middle field of Fig. 4, at a point in time at which 120 seconds have elapsed since the start point in time of the supply of the processing liquid, the resist film in the inner portion R1 of the first sample substrate is hardly removed. However, the resist film in the outer portion R2 of the first sample substrate is removed. The resist-film removal rate in the first sample substrate at this time was about 58 %.

As shown in the lower field of Fig. 4, at a point in time at which 180 seconds have elapsed since the start point in time of the supply of the processing liquid, as compared with a point in time at which 120 seconds have elapsed since the start point in time of the supply of the processing liquid, a wider range of the resist film in the inner portion R1 of the first sample substrate is removed. In the inner portion R1 of the first sample substrate, portions from which the resist film is removed are dispersed relatively uniformly. The resist-film removal rate in the first sample substrate at this time was about 76 %.

Next, the inventor of the present invention positioned the nozzle 30 such that the nozzle 30 is opposite to the center of the substrate W with the second sample substrate held in a horizontal posture and rotated by the spin chuck 1. The inventor of the present invention also opened the two valves 12a, 25a of the processing liquid supply device 3 of Fig. 1 and closed the valves 23a, 24a.

Here, in the processing liquid supply device 3, each of the adjusters 12b, 23b, 24b, 25b adjusts a flow rate of liquid such that, in a case in which the liquid flows through the pipe to which the adjuster is attached, the flow rate of liquid is a predetermined flow rate.

In this case, in the processing liquid supply device 3, the sulfuric acid is supplied from the first liquid supply source 11 to the first pipe 12 at the predetermined flow rate. Further, the hydrogen peroxide solution is supplied from the second liquid supply source 21 to the third portion MP3 of the liquid flow path through the second main pipe 22 and the second sub-pipe 25. Thus, the sulfuric acid and the hydrogen peroxide solution merge in the third portion MP3 (inside of the nozzle 30 in the present example), and the mixed liquid is discharged from the nozzle 30.

The inventor of the present invention captured an image of one surface of the second sample substrate using a camera every sixty seconds from the start point in time of the supply of the processing liquid to the second sample substrate. Further, based on the image obtained by imaging, the inventor of the present invention observed a temporal change of the resist film during the removal process for the second sample substrate.

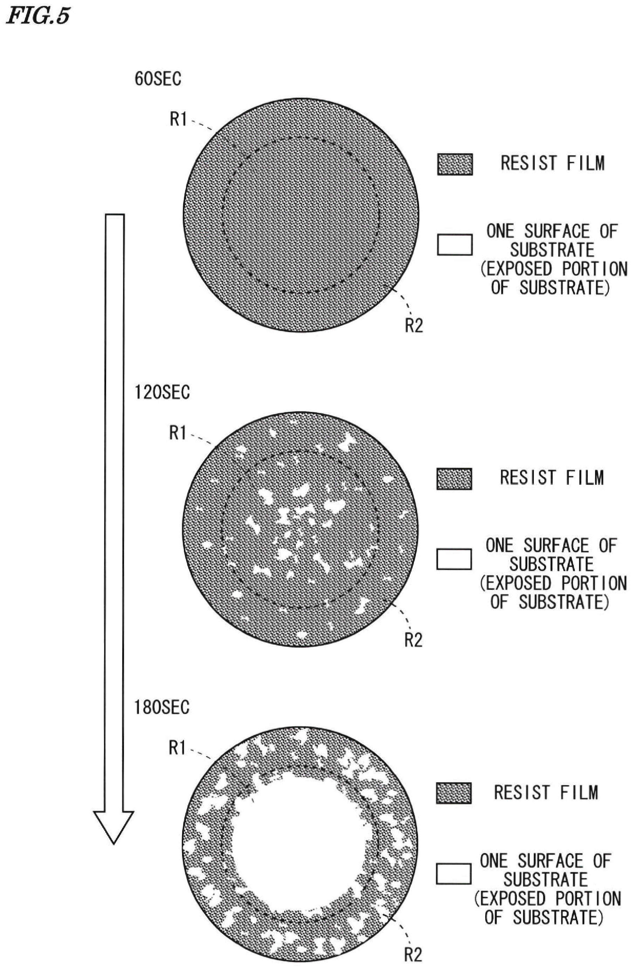

Fig. 5 is a schematic diagram showing a result of a film removal experiment on the second sample substrate. In the upper field of Fig. 5, a plan view of the second sample substrate at a point in time at which sixty seconds have elapsed since the start point in time of the supply of the processing liquid is shown. In the middle field of Fig. 5, a plan view of the second sample substrate at a point in time at which 120 seconds have elapsed since the start point in time of the supply of the processing liquid is shown. In the lower field of Fig. 5, a plan view of the second sample substrate at a point in time at which 180 seconds have elapsed since the start point in time of the supply of the processing liquid is shown.

Similarly to each plan view of Fig. 4, each plan view of Fig. 5 schematically shows the image of the second sample substrate obtained by imaging the second sample substrate. In each of the plan views in the upper, middle, and lower fields of Fig. 5, the resist film present on the one surface of the second sample substrate is indicated by the dotted pattern.

As shown in the upper field of Fig. 5, at a point in time at which sixty seconds have elapsed since the start point in time of the supply of the processing liquid, the resist film is hardly removed from the entire second sample substrate. The resist-film removal rate in the second sample substrate at this time was about 4 %.

As shown in the middle field of Fig. 5, at a point in time at which 120 seconds have elapsed since the start point in time of the supply of the processing liquid, the resist film is sparsely removed from the entire second sample substrate. The resist-film removal rate in the second sample substrate at this time was about 19 %.

As shown in the lower field of Fig. 5, at a point in time at which 180 seconds have elapsed since the start point in time of the supply of the processing liquid, a large part of the resist film in the inner portion R1 of the second sample substrate is removed. However, a relatively large amount of the resist film in the outer portion R2 of the second sample substrate remains. The resist-film removal rate in the second sample substrate at this time was about 75 %.

As described above, the removal process was executed on the first sample substrate by using the processing liquid generated by supplying the hydrogen peroxide solution to the two portions (the first portion MP1 and the second portion MP2) of the liquid flow path farther upstream than the nozzle 30. Thus, it was confirmed that, in the first sample substrate, the resist film tended to be removed sequentially from the outer portion R2 toward the inner portion R1.

On the other hand, the removal process was executed on the second sample substrate using the processing liquid generated by supplying the hydrogen peroxide solution only to the portion (the third portion MP3) of the nozzle 30 of the liquid flow path. Thus, it was confirmed that, in the second sample substrate, the resist film tended to be removed sequentially from the inner portion R1 toward the outer portion R2.

As a result, the inventor of the present invention has found that the method of generating the processing liquid contributes to the non-uniformity of removal of the resist film. Based on this finding, the inventor of the present invention considered that, during the removal process for the one substrate W, the resist film could be efficiently removed from the entire one surface of the one substrate W by switching the method of generating the processing liquid among a plurality of methods. More specifically, the inventor of the present invention focused on the non-uniformity of removal of the resist film, which occurred concentrically from the center (center portion) to the peripheral edge (peripheral portion) of the substrate W due to the method of generating the processing liquid. On that basis, the inventor of the present invention considered that, during the removal process for the substrate W, the resist film could be efficiently removed by switching the portions (MP1, MP2, MP3) where the sulfuric acid and the hydrogen peroxide solution merge.

### <4> One Example of Work Conditions Stored in Storage Device 64

As described above, during the removal process for the one substrate W, in order to switch the method of generating the processing liquid among the plurality of methods, it is necessary to set a work condition of the substrate processing apparatus 100 for each method of generating the processing liquid.

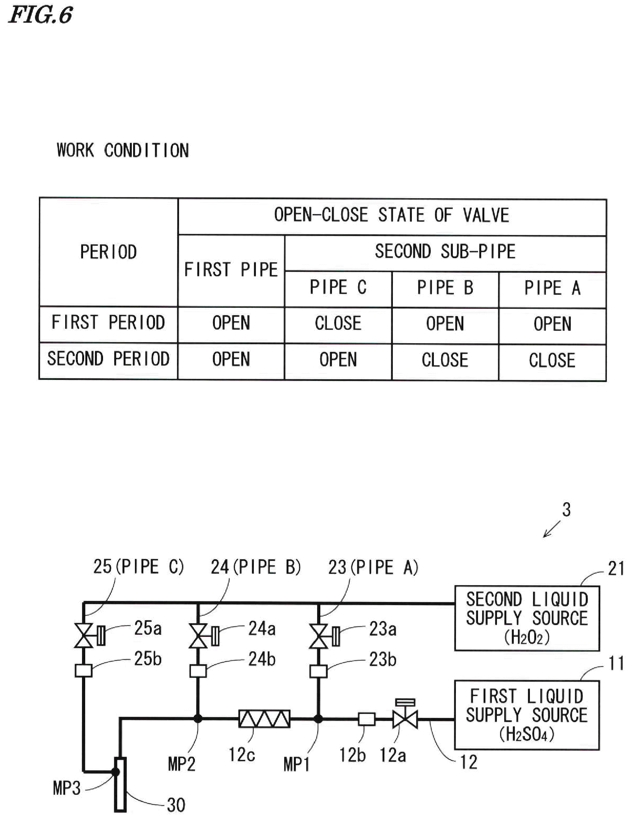

Fig. 6 is a diagram showing one example of the work conditions stored in the storage device 64 of Fig. 3. In the present example, the substrate W of the same type as that of the first sample substrate and the second sample substrate in Figs. 4 and 5 is subjected to the removal process. Further, during the removal process for the one substrate W, the method of generating the processing liquid is switched between two methods. Specifically, in a period during which the removal process is executed on the one substrate W, the processing liquid is generated by one generation method in a first period, and the processing liquid is generated by another generation method in a second period following the first period. In this case, the work condition corresponding to each of the first period and the second period is set.

In the upper field of Fig. 6, the two work conditions set to respectively correspond to the first period and the second period during the removal process are shown using a table. Further, in the lower field of Fig. 6, in order to facilitate understanding of the table, the configuration diagram of the processing liquid supply device 3 is shown. As shown in the lower field of Fig. 6, in the following description, in a case in which the plurality of second sub-pipes 23, 24, 25 of the processing liquid supply device 3 are distinguished from one another, the second sub-pipe 23 is referred to as a "pipe A," the second sub-pipe 24 is referred to as a "pipe B," and the second sub-pipe 25 is referred to as a "pipe C."

In the example in the upper field of Fig. 6, the open-close state of the valve 12a of the first pipe 12 is set to "OPEN," the open-close state of the valve 23a of the pipe A is set to "OPEN," the open-close state of the valve 24a of the pipe B is set to "OPEN," and the open-close state of the valve 25a of the pipe C is set to "CLOSE" during the first period. In a case in which the processing liquid supply device 3 is controlled according to this work condition, the hydrogen peroxide solution is supplied to the sulfuric acid or the mixed liquid flowing through the first pipe 12 in the first portion MP1 and the second portion MP2 of the liquid flow path. Thus, in the first period, the resist film on the substrate W is removed sequentially from the outer periphery of the substrate W toward the center portion of the substrate W, for example. That is, the resist film in the outer portion R2 of the substrate W is preferentially removed (see Fig. 4).

In the example in the upper field of Fig. 6, the open-close state of the valve 12a of the first pipe 12 is set to "OPEN," the open-close state of the valve 23a of the pipe A is set to "CLOSE," the open-close state of the valve 24a of the pipe B is set to "CLOSE," and the open-close state of the valve 25a of the pipe C is set to "OPEN" during the second period. In a case in which the processing liquid supply device 3 is controlled according to this work condition, the hydrogen peroxide solution is supplied to the sulfuric acid flowing through the first pipe 12 in the third portion MP3 of the liquid flow path. Thus, in the second period, the resist film on the substrate W is removed sequentially from the center portion of the substrate W toward the outer periphery of the substrate W, for example. That is, the resist film in the inner portion R1 of the substrate W is preferentially removed (see Fig. 5).

With the above-mentioned work condition, between the first period and the second period, the portion of the resist film to be preferentially removed is changed. Therefore, by appropriately determining the first period and the second period, it is possible to shorten a period of time required for removing the resist film from the entire one surface of the substrate W. The first period and the second period considered to be appropriate for shortening the period of time required for the removal process can be obtained by an experiment or a simulation, for example. The correspondence between the position on the substrate W from which the resist film is preferentially removed and the selection of the portion (MP1, MP2, MP3) where the sulfuric acid and the hydrogen peroxide solution merge is determined by a prior experiment. In the present embodiment, in regard to each position located at a concentric circle on the substrate W from which the resist film is preferentially removed, the method of selecting the portion (MP1, MP2, MP3) where the sulfuric acid and the hydrogen peroxide solution merge is obtained.

### <5> Film Removal Process by Controller 6

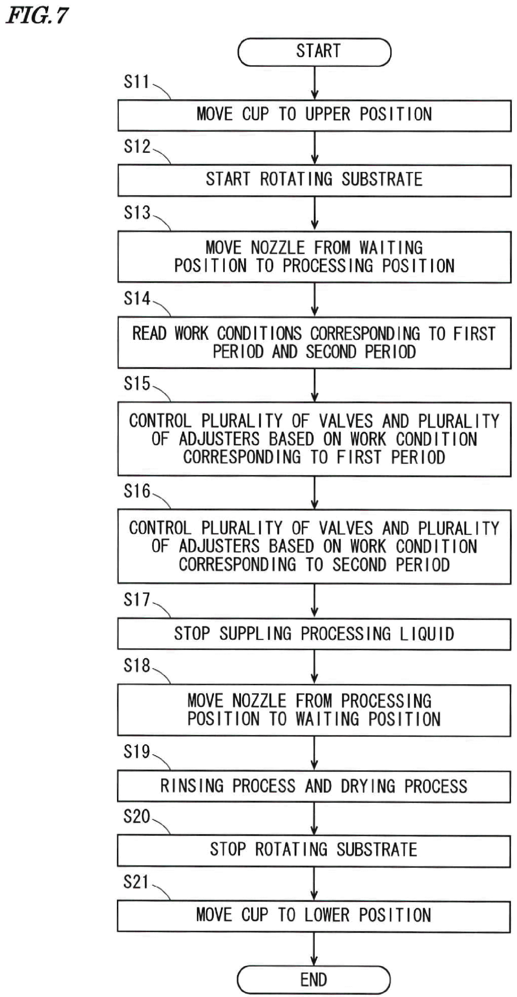

Fig. 7 is a flowchart showing one example of a film removal process executed by the controller 6 of Fig. 1. The below-mentioned film removal process is executed when the CPU 61 of the controller 6 executes, on the RAM 62, a film removal program stored in the storage device 64.

The film removal process executed by the controller 6 is started in response to, for example, an unprocessed substrate W (the substrate W having the resist film formed on the entire surface thereof) being carried into the chamber of the substrate processing apparatus 100 and placed on the spin chuck 1. In an initial state, the cup 2 is located at the lower position, and the nozzle 30 is located at the waiting position WP. Further, all of the plurality of valves 12a, 23a, 24a, 25a of the processing liquid supply device 3 are kept in the close state. Further, two work conditions of the processing liquid supply device 3 respectively corresponding to the first period and the second period during the removal process are stored in the storage device 64 of the controller 6.

When the film removal process is started, the CPU 61 controls the cup lifting-lowering device 2D to move the cup 2 from the lower position to the upper position (step S11). Further, the CPU 61 controls the spin motor 1a to rotate the substrate W held by the plurality of chuck pins 1c on the spin base 1b (step S12). Further, the CPU 61 controls the nozzle moving device 5 to move the nozzle 30 of the processing liquid supply device 3 from the waiting position WP to the processing position PP (step S13).

Subsequently, the CPU 61 reads the work conditions respectively corresponding to the first period and the second period stored in the storage device 64 (step S14). Next, in the predetermined first period, the CPU 61 controls the plurality of valves 12a, 23a, 24a, 25a and the plurality of adjusters 12b, 23b, 24b, 25b of the processing liquid supply device 3 based on the work condition corresponding to the first period (step S15). This causes a portion of the resist film on the one surface of the substrate W to be removed preferentially compared to other portions of the resist film on the one surface of the substrate W.

When the first period ends, the CPU 61 controls the plurality of valves 12a, 23a, 24a, 25a and the plurality of adjusters 12b, 23b, 24b, 25b of the processing liquid supply device 3 based on the work condition corresponding to the second period (step S16). This causes the other portions of the resist film on the one surface of the substrate W to be removed preferentially compared to the one portion of the resist film on the one surface of the substrate W.

When the second period ends, the CPU 61 closes the plurality of valves 12a, 23a, 24a, 25a of the processing liquid supply device 3 to stop supplying the processing liquid (step S17).

Next, the CPU 61 controls the nozzle moving device 5 to move the nozzle 30 of the processing liquid supply device 3 from the processing position PP to the waiting position WP (step S18). Further, by controlling a rinse liquid supply system (not shown) and the spin motor 1a, the CPU 61 executes the rinsing process and a drying process on the substrate W from which the resist film has been removed (step S19). The drying process in the step S19 is a so-called spin drying process of rotating the substrate W at a high speed after the rinsing process to dry the substrate W.

After the drying process in the step S19 ends, the CPU 61 controls the spin motor 1a to stop rotation of the substrate W (step S20). Further, the CPU 61 controls the cup lifting-lowering device 2D to move the cup 2 from the upper position to the lower position (step S21), and ends a series of processes.

### <6> Effects

(a) In the above-mentioned substrate processing apparatus 100, in the first period during the removal process for the one substrate W, the sulfuric acid and the hydrogen peroxide solution are mixed in the first portion MP1 and the second portion MP2 of the liquid flow path. On the other hand, the sulfuric acid and the hydrogen peroxide solution are not mixed in the third portion MP3 of the liquid flow path. The first portion MP1 and the second portion MP2 are located at positions largely separated from the downstream end of (the discharge port of the nozzle 30) of the liquid flow path. The processing liquid obtained by mixing is supplied to the one substrate W. The processing liquid supplied to the one substrate W at this time is referred to as a first processing liquid.

Further, in the second period during the removal process for the one substrate W, the sulfuric acid and the hydrogen peroxide solution are mixed in the third portion MP3 of the liquid flow path. On the other hand, the sulfuric acid and the hydrogen peroxide solution are not mixed in the first portion MP1 or the second portion MP2 of the liquid flow path. The third portion MP3 is located close to the downstream end (the discharge port of the nozzle 30) of the liquid flow path. The processing liquid obtained by mixing is supplied to the one substrate W. The processing liquid supplied to the one substrate W at this time is referred to as a second processing liquid.

In a case in which the first processing liquid is supplied to the one surface of the one substrate W, the resist film is likely to be removed from a first portion of the plurality of portions of the one substrate W, and the resist film is unlikely to be removed from other portions of the plurality of portions of the one substrate W. Further, in a case in which the second processing liquid is supplied to the one surface of the one substrate W, the resist film is likely to be removed from a second portion different from the first portion of the plurality of portions of the one substrate W, and the resist film is unlikely to be removed from other portions of the plurality of portions of the one substrate W. Therefore, by appropriately setting the first period and the second period, it is possible to shorten a period of time required for removing the resist film from the entire one surface of the substrate W. As a result, efficiency of processing the substrate W is improved.
(b) The stirrer 12c is provided in the first pipe 12 of the processing liquid supply device 3. In the first period during the removal process, the hydrogen peroxide solution is supplied from the two second sub-pipes 23, 24 to the two portions (the first portion MP1 and the second portion MP2) between which the stirrer 12c is provided in the liquid flow path.

In this case, in the first period, the sulfuric acid and the hydrogen peroxide solution merge upstream of the stirrer 12c, and flow into the stirrer 12c. In the stirrer 12c, the liquid passing inside of the stirrer 12c is stirred, whereby the chemical reaction between the sulfuric acid and the hydrogen peroxide solution is promoted, and a certain amount of Caro's acid is generated.

Thereafter, the hydrogen peroxide solution further joins the mixed liquid that has passed through the stirrer 12c. In this case, the chemical reaction between the newly added hydrogen peroxide solution and the sulfuric acid in the mixed liquid further occurs. This enables the processing liquid having a high concentration of Caro's acid to be supplied to the one surface of the substrate W.

### <7> Other Embodiments

(a) While the first period and the second period are set for switch of the method of generating the processing liquid during the removal process in the substrate processing apparatus 100 according to the above-mentioned embodiment, the present invention is not limited to this.

In one removal process for the one substrate W, the processing liquid may be generated using a plurality (three or more) of methods. For example, in addition to the first period corresponding to the first processing-liquid generation method and the second period corresponding to the second processing-liquid generation method, a third period corresponding to a third processing-liquid generation method may be set. In this manner, in a case in which the first period, the second period, and the third period are set, the storage device 64 stores work conditions respectively corresponding to the first period, the second period, and the third period.

Alternatively, in addition to the first period corresponding to the first processing-liquid generation method, the second period corresponding to the second processing-liquid generation method, and the third period corresponding to a third processing-liquid generation period, a fourth period corresponding to a fourth processing-liquid generation method may be set. In this manner, in a case in which the first period, the second period, the third period, and the fourth period are set, the storage device 64 stores work conditions respectively corresponding to the first period, the second period, the third period, and the fourth period.
(b) While the work of the processing liquid supply device 3 is controlled such that the first period is followed by the second period in chronological order during the removal process in the substrate processing apparatus 100 according to the above-mentioned embodiment, the present invention is not limited to this.

In the substrate processing apparatus 100, the work of the processing liquid supply device 3 may be controlled during the removal process on the assumption that the second period is followed by the first period in chronological order. In this case, according to the work condition of Fig. 6, in the second period, the open-close state of the valve 12a of the first pipe 12 is set to "OPEN," the open-close state of the valve 23a of the pipe A is set to "OPEN," the open-close state of the valve 24a of the pipe B is set to "CLOSE," and the open-close state of the valve 25a of the pipe C is set to "CLOSE." Thereafter, in the first period, the open-close state of the valve 12a of the first pipe 12 is set to "OPEN," the open-close state of the valve 23a of the pipe A is set to "OPEN," the open-close state of the valve 24a of the pipe B is set to "OPEN," and the open-close state of the valve 25a of the pipe C is set to "CLOSE."
(c) In the processing liquid supply device 3 of the substrate processing apparatus 100 according to the above-mentioned embodiment, the first liquid supply source 11 is a supply source of the sulfuric acid, and the second liquid supply source 21 is a supply source of the hydrogen peroxide solution. However, the present invention is not limited to this. In the above-mentioned processing liquid supply device 3, the first liquid supply source 11 may be a supply source of the hydrogen peroxide solution, and the second liquid supply source 21 may be a supply source of the sulfuric acid.
(d) While the stirrer 12c is provided in the first pipe 12 of the processing liquid supply device 3 according to the above-mentioned embodiment, the stirrer 12c does not have to be provided.
(e) While the second liquid supply system 20 of the processing liquid supply device 3 according to the above-mentioned embodiment includes the three second sub-pipes 23, 24, 25 as pipes for mixing the hydrogen peroxide solution with the sulfuric acid, the present invention is not limited to this. The second liquid supply system 20 may include only two second sub-pipes or may include four or more second sub-pipes. In a case in which the second liquid supply system 20 has four or more second sub-pipes, the sulfuric acid and the hydrogen peroxide solution can be mixed in four or more portions of the liquid flow path formed by the first pipe 12 and the nozzle 30. This improves a degree of freedom of the work condition that can be set for generating the processing liquid.
(f) While the sulfuric acid and the hydrogen peroxide solution are mixed in the first portion MP1 and the second portion MP2 of the liquid flow path in the first period during the removal process, the present invention is not limited to this. In the first period during the removal process, the sulfuric acid and the hydrogen peroxide solution may be mixed in all of the first portion MP1, the second portion MP2, and the third portion MP3 of the liquid flow path. Alternatively, in the first period during the removal process, the sulfuric acid and the hydrogen peroxide solution may be mixed in the first portion MP1 and the third portion MP3 of the liquid flow path, or the sulfuric acid and the hydrogen peroxide solution may be mixed in the second portion MP2 and the third portion MP3 of the liquid flow path.
(g) While the rinsing process and the drying process are executed in this order after the processing liquid including Caro's acid is supplied to the substrate W in the film removal process according to the above-mentioned embodiment, the present invention is not limited to this. The substrate processing apparatus 100 may include a supply device (SC1 supply device) that supplies, to the substrate W held by the spin chuck 1, a mixed liquid (SC1) of ammonium water and a hydrogen peroxide solution as another processing liquid. In this case, between the above-mentioned rinsing process and the above-mentioned drying process, the SC1 supply device may supply the SC1 to the substrate W and may stop supplying the SC1 to the substrate W, and an additional rinsing process for washing away the SC1 remaining on the substrate W may be executed.

### <8> Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. As each of various elements recited in the claims, various other elements having configurations or functions described in the claims can be also used.

In the above-mentioned embodiment, the resist film is an example of an unnecessary film, the substrate processing apparatus 100 is an example of a substrate processing apparatus, the nozzle 30 is an example of a nozzle, the first pipe 12 is an example of a first pipe, the first liquid supply system 10 is an example of a first liquid supply system, and the first portion MP1, the second portion MP2, and the third portion MP3 of the liquid flow path are examples of a plurality (three or more) of different portions of a liquid flow path.

Further, the second sub-pipe 23, the second sub-pipe 24, and the second sub-pipe 25 of the second liquid supply system 20 are examples of a plurality of second pipes, the second liquid supply system 20 is an example of a second liquid supply system, the second liquid supply system 20 is an example of a second liquid supply system, and the controller 6 is an example of a controller.

Further, the second sub-pipe 25 is an example of a downstream pipe, the second sub-pipe 23 and the second sub-pipe 24 are examples of a plurality of upstream pipes, the stirrer 12c is an example of a stirrer, the spin chuck 1 is an example of a rotation holder, the nozzle supporter 4 is an example of a nozzle supporter, the valves 23a, 24a, 25a are examples of a plurality of open-close valves, the control of the processing liquid supply device 3 according to the work condition corresponding to the first period is an example of a first control, and the control of the processing liquid supply device 3 according to the work condition corresponding to the second period is an example of a second control.

### <9> <Overview of Embodiments>

(Item 1) A substrate processing apparatus according to item 1 executes a removal process of removing, using a processing liquid including Caro's acid, an unnecessary film formed on one surface of a substrate, wherein in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid, the substrate processing apparatus includes a nozzle that discharges the processing liquid to the one surface of the substrate, a first liquid supply system that includes a first pipe connected to the nozzle, and supplies the first liquid to the nozzle through the first pipe, a second liquid supply system that includes a plurality of second pipes respectively connected to a plurality of different portions of a liquid flow path formed by the nozzle and the first pipe, and supplies the second liquid to the liquid flow path through any one of the plurality of second pipes, and a count of the plurality of second pipes and a count of the plurality of different portions are respectively equal to or larger than three, and a controller that controls the second liquid supply system, the plurality of second pipes include a downstream pipe connected to a most downstream portion among the plurality of portions of the liquid flow path, and a plurality of upstream pipes excluding the downstream pipe, and the controller executes a first control of, in a first period during the removal process for one substrate, not causing the second liquid to flow through the downstream pipe and causing the second liquid to flow through at least two upstream pipes among the plurality of upstream pipes, and executes a second control of, in a second period during the removal process for the one substrate, causing the second liquid to flow through the downstream pipe and not causing the second liquid to flow through the plurality of upstream pipes.

In the substrate processing apparatus, in the first period during the removal process for the one substrate, the first liquid flowing through the first pipe and the second liquid flowing through the at least two upstream pipes are mixed at the plurality of positions separated from the discharge port of the nozzle, and supplied to the one substrate. The processing liquid supplied to the substrate at this time is referred to as the first processing liquid.

Further, in the second period during the removal process for the one substrate, the first liquid flowing through the first pipe and the second liquid flowing through the downstream pipe are mixed at a position close to the discharge port of the nozzle, and supplied to the one substrate. The processing liquid supplied to the substrate at this time is referred to as the second processing liquid.

In a case in which the first processing liquid is supplied to the one surface of the substrate, the film is likely to be removed from the first portion of the plurality of portions of the substrate, and the film is unlikely to be removed from other portions of the plurality of portions of the substrate. Further, in a case in which the second processing liquid is supplied to the one surface of the substrate, the film is likely to be removed from the second portion different from the first portion of the plurality of portions of the substrate, and the film is unlikely to be removed from other portions of the plurality of portions of the substrate. Therefore, by appropriately setting the first period and the second period, it is possible to shorten a period of time required for removing the film from the entire one surface of the substrate. As a result, efficiency of processing the substrate is improved.

(Item 2) The substrate processing apparatus according to item 1, may further include a stirrer provided in the first pipe, wherein in the first control, the controller may cause the second liquid to flow through two upstream pipes connected to two portions between which the stirrer is provided in the liquid flow path.

In this case, in the first period, the first liquid and the second liquid merge upstream of the stirrer, and flow into the stirrer. By stirring the first liquid and the second liquid, the chemical reaction between the first liquid and the second liquid is promoted, and a certain amount of Caro's acid is generated.

Thereafter, the second liquid further joins the mixed liquid that has passed through the stirrer. In this case, the chemical reaction between the newly added second liquid and the first liquid in the mixed liquid further occurs. This enables the processing liquid having a high concentration of Caro's acid to be supplied to the one surface of the substrate.

(Item 3) The substrate processing apparatus according to item 1 or 2, may further include a rotation holder that holds and rotates the one substrate during the removal process for the one substrate, and a nozzle supporter that, during the removal process for the one substrate, supports the nozzle at a position above the one substrate such that a discharge port of the nozzle is opposite to a rotation center of the one substrate.

In this case, during the removal process for the one substrate, the processing liquid is supplied to the rotation center of the one surface of the substrate. The processing liquid that has been supplied to the rotation center of the substrate spreads toward the outer peripheral end of the substrate due to a centrifugal force. This causes the processing liquid to be supplied to the entire one surface of the substrate.

(Item 4) The substrate processing apparatus according to any one of items 1 to 3, wherein the second liquid supply system may further include a plurality of open-close valves respectively provided in the plurality of second pipes, and the controller may control liquid flow states in the plurality of second pipes by controlling open-close states of the plurality of open-close valves.

In this case, the state of the processing liquid supplied to the substrate can be adjusted with a simple configuration.

(Item 5) A substrate processing method according to item 5 is executed using a substrate processing apparatus, with the substrate processing apparatus executing a removal process of removing, using a processing liquid including Caro's acid, an unnecessary film formed on one surface of a substrate, wherein in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid, the substrate processing apparatus includes a nozzle that discharges the processing liquid to the one surface of the substrate, a first liquid supply system that includes a first pipe connected to the nozzle, and supplies the first liquid to the nozzle through the first pipe, a second liquid supply system that includes a plurality of second pipes respectively connected to a plurality of different portions of a liquid flow path formed by the nozzle and the first pipe, and supplies the second liquid to the liquid flow path through any one of the plurality of second pipes, and a count of the plurality of second pipes and a count of the plurality of different portions are respectively equal to or larger than three, and the plurality of second pipes include a downstream pipe connected to a most downstream portion among the plurality of portions of the liquid flow path, and a plurality of upstream pipes excluding the downstream pipe, and the substrate processing method includes the steps of executing a first control of, in a first period during the removal process for one substrate, not causing the second liquid to flow through the downstream pipe and causing the second liquid to flow through at least two upstream pipes among the plurality of upstream pipes, and executing a second control of, in a second period during the removal process for the one substrate, causing the second liquid to flow through the downstream pipe and not causing the second liquid to flow through the plurality of upstream pipes.

With the substrate processing method, in the first period during the removal process for the one substrate, the first liquid flowing through the first pipe and the second liquid flowing through the at least two upstream pipes are mixed at the plurality of positions separated from the discharge port of the nozzle, and supplied to the one substrate. The processing liquid supplied to the substrate at this time is referred to as the first processing liquid.

Further, in the second period during the removal process for the one substrate, the first liquid flowing through the first pipe and the second liquid flowing through the downstream pipe are mixed at a position close to the discharge port of the nozzle, and supplied to the one substrate. The processing liquid supplied to the substrate at this time is referred to as the first processing liquid.

In a case in which the first processing liquid is supplied to the one surface of the substrate, the film is likely to be removed from the first portion of the plurality of portions of the substrate, and the film is unlikely to be removed from other portions of the plurality of portions of the substrate. Further, in a case in which the second processing liquid is supplied to the one surface of the substrate, the film is likely to be removed from the second portion different from the first portion of the plurality of portions of the substrate, and the film is unlikely to be removed from other portions of the plurality of portions of the substrate. Therefore, by appropriately setting the first period and the second period, it is possible to shorten a period of time required for removing the film from the entire one surface of the substrate. As a result, efficiency of processing the substrate is improved.

(Item 6) The substrate processing method according to item 5, wherein the substrate processing apparatus may further include a stirrer provided in the first pipe, and the step of executing the first control may include causing the second liquid to flow through two upstream pipes connected to two portions between which the stirrer is provided in the liquid flow path.

In this case, in the first period, the first liquid and the second liquid merge upstream of the stirrer, and flow into the stirrer. By stirring the first liquid and the second liquid, the chemical reaction between the first liquid and the second liquid is promoted, and a certain amount of Caro's acid is generated.

Thereafter, the second liquid further joins the mixed liquid that has passed through the stirrer. In this case, the chemical reaction between the newly added second liquid and the first liquid in the mixed liquid further occurs. This enables the processing liquid having a high concentration of Caro's acid to be supplied to the one surface of the substrate.

(Item 7) The substrate processing method according to item 5 or 6, may further include the steps of holding and rotating the one substrate using a rotation holder during the removal process for the one substrate, and during the removal process for the one substrate, supporting the nozzle at a position above the one substrate using a nozzle supporter such that a discharge port of the nozzle is opposite to a rotation center of the one substrate.

In this case, during the removal process for the one substrate, the processing liquid is supplied to the rotation center of the one surface of the substrate. The processing liquid that has been supplied to the rotation center of the substrate spreads toward the outer peripheral end of the substrate due to a centrifugal force. This causes the processing liquid to be supplied to the entire one surface of the substrate.

(Item 8) The substrate processing method according to any one of items 5 to 7, wherein the second liquid supply system may further include a plurality of open-close valves respectively provided in the plurality of second pipes, and each of the step of executing the first control and the step of executing the second control may include controlling liquid flow states in the plurality of second pipes by controlling open-close states of the plurality of open-close valves.

In this case, the state of the processing liquid supplied to the substrate can be adjusted with a simple configuration.

With the substrate processing apparatus and the substrate processing method according to the series of above-mentioned embodiments, the efficiency of processing the substrate is improved, and thus, the wasteful consumption of the processing liquid is suppressed. This eliminates the need to prepare a large amount of processing liquid. Thus, it is possible to contribute to a reduction in pollution of a global environment caused by the processing liquid.

## Claims

1. A substrate processing apparatus that executes a removal process of removing, using a processing liquid including Caro's acid, an unnecessary film formed on one surface of a substrate, wherein
in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid,
the substrate processing apparatus includes
a nozzle that discharges the processing liquid to the one surface of the substrate,
a first liquid supply system that includes a first pipe connected to the nozzle, and supplies the first liquid to the nozzle through the first pipe,
a second liquid supply system that includes a plurality of second pipes respectively connected to a plurality of different portions of a liquid flow path formed by the nozzle and the first pipe, and supplies the second liquid to the liquid flow path through any one of the plurality of second pipes, and a count of the plurality of second pipes and a count of the plurality of different portions are respectively equal to or larger than three, and
a controller that controls the second liquid supply system,
the plurality of second pipes include a downstream pipe connected to a most downstream portion among the plurality of portions of the liquid flow path, and a plurality of upstream pipes excluding the downstream pipe, and
the controller executes a first control of, in a first period during the removal process for one substrate, not causing the second liquid to flow through the downstream pipe and causing the second liquid to flow through at least two upstream pipes among the plurality of upstream pipes, and executes a second control of, in a second period during the removal process for the one substrate, causing the second liquid to flow through the downstream pipe and not causing the second liquid to flow through the plurality of upstream pipes.

2. The substrate processing apparatus according to claim 1, further comprising a stirrer provided in the first pipe, wherein
in the first control, the controller causes the second liquid to flow through two upstream pipes connected to two portions between which the stirrer is provided in the liquid flow path.

3. The substrate processing apparatus according to claim 1 or 2, further comprising:
a rotation holder that holds and rotates the one substrate during the removal process for the one substrate; and
a nozzle supporter that, during the removal process for the one substrate, supports the nozzle at a position above the one substrate such that a discharge port of the nozzle is opposite to a rotation center of the one substrate.

4. The substrate processing apparatus according to any one of claims 1 to 3, wherein
the second liquid supply system further includes a plurality of open-close valves respectively provided in the plurality of second pipes, and
the controller controls liquid flow states in the plurality of second pipes by controlling open-close states of the plurality of open-close valves.

5. A substrate processing method executed using a substrate processing apparatus, the substrate processing apparatus executing a removal process of removing, using a processing liquid including Caro's acid, an unnecessary film formed on one surface of a substrate, wherein
in a case in which one of sulfuric acid and a hydrogen peroxide solution is a first liquid, and another one of the sulfuric acid and the hydrogen peroxide solution is a second liquid, the Caro's acid is generated by mixing the first liquid and the second liquid,
the substrate processing apparatus includes
a nozzle that discharges the processing liquid to the one surface of the substrate,
a first liquid supply system that includes a first pipe connected to the nozzle, and supplies the first liquid to the nozzle through the first pipe,
a second liquid supply system that includes a plurality of second pipes respectively connected to a plurality of different portions of a liquid flow path formed by the nozzle and the first pipe, and supplies the second liquid to the liquid flow path through any one of the plurality of second pipes, and a count of the plurality of second pipes and a count of the plurality of different portions are respectively equal to or larger than three, and
the plurality of second pipes include a downstream pipe connected to a most downstream portion among the plurality of portions of the liquid flow path, and a plurality of upstream pipes excluding the downstream pipe, and
the substrate processing method includes the steps of
executing a first control of, in a first period during the removal process for one substrate, not causing the second liquid to flow through the downstream pipe and causing the second liquid to flow through at least two upstream pipes among the plurality of upstream pipes, and
executing a second control of, in a second period during the removal process for the one substrate, causing the second liquid through the downstream pipe and not causing the second liquid to flow through the plurality of upstream pipes.

6. The substrate processing method according to claim 5, wherein
the substrate processing apparatus further includes a stirrer provided in the first pipe, and
the step of executing the first control includes causing the second liquid to flow through two upstream pipes connected to two portions between which the stirrer is provided in the liquid flow path.

7. The substrate processing method according to claim 5 or 6, further including the steps of:
holding and rotating the one substrate using a rotation holder during the removal process for the one substrate; and
during the removal process for the one substrate, supporting the nozzle at a position above the one substrate using a nozzle supporter such that a discharge port of the nozzle is opposite to a rotation center of the one substrate.

8. The substrate processing method according to any one of claims 5 to 7, wherein
the second liquid supply system further includes a plurality of open-close valves respectively provided in the plurality of second pipes, and
each of the step of executing the first control and the step of executing the second control includes controlling liquid flow states in the plurality of second pipes by controlling open-close states of the plurality of open-close valves.
